(19) Europäisches Patentamt
European Patent Office
Office européen des brevets

(11) **EP 1 720 274 B1**

(12) **EUROPÄISCHE PATENTSCHRIFT**

(45) Veröffentlichungstag und Bekanntmachung des Hinweises auf die Patenterteilung:
**15.04.2009 Patentblatt 2009/16**

(51) Int Cl.:
***H04L 1/00*** *(2006.01)*

(21) Anmeldenummer: **06009241.8**

(22) Anmeldetag: **04.05.2006**

(54) **Verfahren und Vorrichtung zum Übertragen von Fehlerkorrektursymbolen bei Verwendung eines zweidimensionalen Reed-Solomon-Codes**

Method and apparatus for transmitting error correction symbols when using a two-dimensional Reed-Solomon code

Procédé et dispositif pour la transmission de symboles de correction d'erreurs utilisant un code Reed-Solomon bidimensionel

(84) Benannte Vertragsstaaten:
**DE FR GB IT**

(30) Priorität: **04.05.2005 DE 102005021347**

(43) Veröffentlichungstag der Anmeldung:
**08.11.2006 Patentblatt 2006/45**

(73) Patentinhaber: **BenQ Corporation**
**Gueishan**
**Taoyung 333 (TW)**

(72) Erfinder:
• **Xu, Wen**
  **85579 Neubiberg (DE)**
• **Stockhammer, Thomas**
  **83346 Bergen (DE)**
• **Pandel, Jürgen**
  **82620 Feldkirchen-Westerham (DE)**
• **Gasiba, Tiago**
  **80805 München (DE)**

(74) Vertreter: **Görz, Ingo et al**
**Hoefer & Partner**
**Patentanwälte**
**Pilgersheimer Strasse 20**
**81543 München (DE)**

(56) Entgegenhaltungen:
• **WU J ET AL: "INTEGRATED PACKET LOSS AND ERROR CONTROL SCHEMES IN WIRELESS MULTIMEDIA DATA LINKS" GLOBECOM'01. 2001 IEEE GLOBAL TELECOMMUNICATIONS CONFERENCE. SAN ANTONIO, TX, NOV. 25 - 29, 2001, IEEE GLOBAL TELECOMMUNICATIONS CONFERENCE, NEW YORK, NY : IEEE, US, Bd. VOL. 1 OF 6, 25. November 2001 (2001-11-25), Seiten 685-689, XP001090341 ISBN: 0-7803-7206-9**
• **JENKAE H ET AL: "Flexible Outer Reed-Solomon Coding on RLC Layer for MBMS over GERAN" VEHICULAR TECHNOLOGY CONFERENCE, 2004. VTC 2004-SPRING. 2004 IEEE 59TH MILAN, ITALY 17-19 MAY 2004, PISCATAWAY, NJ, USA, IEEE, US, 17. Mai 2004 (2004-05-17), Seiten 2777-2781, XP010766755 ISBN: 0-7803-8255-2**
• **"Efficient FEC Code for Reliable MBMS User Services" TECHNICAL SPECIFICATION GROUP SERVICES AND SYSTEM ASPECTS, TSGS#27 (05)0164, [Online] 14. März 2005 (2005-03-14), Seiten 1-12, XP002391891 Tokyo, Japan Gefunden im Internet: URL:http://www. 3gpp.org/ftp/tsg_sa/TSG_SA/ TSGS_ 27/Docs/PDF/SP-050164.pdf> [gefunden am 2006-07-25]**

EP 1 720 274 B1

## Beschreibung

Die Erfindung betrifft ein Verfahren zur Übertragung von Fehlerkorrektursymbolen für in einer zweidimensionalen Matrix organisierte Quellensymbole und eine Vorrichtung gemäß dem Oberbegriff des Anspruchs 3.

Bei der Übertragung von Datenpaketen, wie z.B. Audio oder Videodaten, von einem Sender zu einem Empfänger kommt es aufgrund von Übertragungsfehler zum fehlerhaften Empfang dieser Datenpakete. Insbesondere bei Download-Diensten kann es erforderlich sein, dass alle Datenpakete fehlerfrei am Empfänger rekonstruiert werden können.

Bei MBMS-Diensten (MBMS - Multimedia Broadcast/Multicast Service), die bspw. bei 3GPP (3GPP - Third Generation Partnership Project) standardisiert werden, werden Datenpakete von einem Sender an mehrere Empfänger übertragen. Dabei können bei verschiedenen Empfängern unterschiedliche Datenpakete fehlerhaft den jeweiligen Empfänger erreichen.

Um einen fehlerfreien Empfang zu gewährleisten könnten die Datenpakete mehrfach übertragen werden, so dass ein fehlerhafter Empfang sehr unwahrscheinlich ist. Diese Vorgehensweise ist jedoch äußerst ineffizient, da allen Empfängern, unabhängig ob ein fehlerhafter Empfang vorliegt, die Datenpakete wiederholt zugeschickt werden.

Daneben kann zusätzlich zu den Datenpaketen ein Fehlerschutz in Form von Paritätsdaten an den Empfänger übermittelt werden. Damit kann eine maximale Anzahl von fehlerhaften Datenpaketen korrigiert werden, jedoch kann damit ein fehlerfreier Empfang nicht garantiert werden. Ein bekanntes Fehlerschutzverfahren ist bspw. das Reed-Solomon Verfahren bzw. das 2D-Reed-Solomon Verfahren (= Zweidimensionales Reed-Solomon Verfahren).

Alternativ oder zusätzlich kann ein Empfänger nach fehlerhaftem Empfang eines oder mehrerer Datenpakete eine Punkt-zu-Punkt Verbindung mit dem Sender aufbauen, um fehlerhafte Daten- und/oder Paritätspakete anzufordern. Hierbei können Daten- und/oder Paritätspakete, die fehlerhaft sind, dediziert in Form von Fehlerkorrekturpaketen angefordert werden. Je mehr Fehlerkorrekturpaketen angefordert werden, desto mehr Bandbreite wird für den MBMS-Dienst benötigt bzw. die Kosten steigen.

Ein Datenpaket kann aus einem oder mehreren Quellensymbolen gebildet werden. Ferner ist ein Paritätspaket aus mindestens einem Paritätssymbol generierbar. Somit besteht ein Fehlerkorrekturpaket aus zumindest einem Quellen- oder Paritätssymbol.

"Wu et al: "Integrated Packet Loss And Error Control Schemes In Wireless Multimedia Data Links", IEEE Global Telecommunications Conference, Bd. 1 von 6, 25.11.2001, Seiten 685-689, XP001090341 ISBN: 0-7803-7206-9" zeigt eine auf einer Vorwärts-Fehlerkorrektur beruhende Technik, wobei eine zweidimensionale Codierung durchgeführt wird. In dem Encoder werden Informationen übermittelnde Pakete vertikal angeordnet, um die 2-D-Matrix zu bilden. Der erste Code wird entlang der horizontalen Richtung angewandt, um die Redundanz-Pakete zu bilden, die hauptsächlich der Wiederherstellung von verloren gegangenen Paketen dienen. Der zweite Code wird entlang der vertikalen Richtung innerhalb der individuellen Pakete angewandt, um die Bitfehlerrate zu minimieren. Im Unterschied zu herkömmlichen 2-D-Codes werden die Spalten des 2-D-Codes (Pakete) als unabhängig Einheiten übertragen.

"Jenkae et al: "Flexible Outer Reed-Solomon Coding on RLC Layer for MBMS over GERAN" Vehicular Technology Conference, 2004, IEEE, 17.5.2004, Seiten 2777-2781, XP010766755 ISBN: 0-7803-8255-2" beschreibt, dass keine individuellen Wiederholungsübertragungen durchgeführt werden, d.h., dass der viel verbreitete und akzeptierte Acknoledged Mode für p-t-p-Service innerhalb GERAN nicht verwendet werden kann. Es wird vorgeschlagen, eine RS-Codierung in der RLC-Schicht durchzuführen, um weniger RLCMAC-Blöcke aufgrund von verbleibenden Bitfehlern zu verwerfen. Die RS-Codierung wird in der Verschachtelungseinheit zeilenweise mit den Daten durchgeführt, so dass jede Zeile ein gültiges Code-Wort der Länge n in Bytes enthält. Durch eine solche äußere RS-Codierung in der RLC-Schicht für MBMS über GERAN werden Datenraten für p-t-M nahe denen des Acknoledged-Mode in p-t-p erreicht, wobei relativ einfache Codier- und Decodier-Operationen durchgeführt werden müssen und eine akzeptierbare Verzögerung auftritt.

"Efficient FEC Code for Reliable MBMS User Services" Technical Specification Group Services And System Aspects, TSGS#27 (05)0164, [Online] 14. März 2008 (2005-03-14), Seiten 1-12, XP002391891 Tokyo, Japan Gefunden im Internet: URL:http://*www.3gpp.org/ftp/tsg_sa/TSG_SA/TSGS_27/Docs/PDF/SP-050164.pdf>[gefunden am 2006-07-25]"*beschreibt, dass verschiedene Varianten von Read-Solomon-Codes (eindimensionale Codes mit und ohne Interleaving, zweidimensionale Codes mit und ohne aufwendige Punktierungsschemata) bestehen und dass eine Vorwärts-Fehler-Korrektur als ein Mechanismus zur Verbesserung der Fehler-Ausfall-Sicherheit eines Datenstroms vorteilhaft ist.

Der Erfindung liegt die Aufgabe zugrunde, ein Verfahren und eine Vorrichtung anzugeben, das/die eine zu übertragende Anzahl von Fehlerkorrektursymbolen zur fehlerfreien Rekonstruktion von Quellensymbolen bei Verwendung eines zweidimensionalen Reed-Solomon-Codes in einfacher und effizienter Weise reduziert.

Diese Aufgabe wird durch die unabhängigen Ansprüche gelöst. Hierbei ermöglicht das erfindungsgemäße Verfahren eine Reduktion der Anzahl von zu übertragenden Fehlerkorrektursymbolen, die zur fehlerfreien Rekonstruktion der Quellensymbole benötigt werden. Dabei wird die für die Übertragung der Fehlerkorrektursymbole benötige Bandbreite reduziert. Ferner wird durch eine geringe Anzahl von zu übertragenden Fehlerkorrektursymbolen eine Reduktion der Übertragungszeit erzielt, da bei realen Übertragungssystemen die Übertragungsbandbreite limitiert ist. Ferner können durch das erfindungsgemäße Verfahren Übertragungskosten eingespart werden, da lediglich eine geringe Anzahl von Fehlerkorrektursymbolen übertragen werden muss. Zusätzlich zeichnet sich die vorliegende Erfindung durch eine geringe Verarbeitungskomplexität aus.

Die Erfindung umfasst eine Vorrichtung zum Durchführen des erfindungsgemäßen Verfahrens. Somit kann das Verfahren implementiert und ausgeführt werden.

Sonstige Weiterbildungen der Erfindung sind in den Unteransprüchen wiedergegeben.

Die Erfindung und ihre Weiterbildungen werden nachfolgend anhand von Figuren näher erläutert.

Es zeigen:

Figur 1 ein Ablaufdiagramm des erfindungsgemäßen Verfahrens;

Figur 2 ein Ausführungsbeispiel des erfindungsgemäßen Verfahrens mit einer Sende- und Empfangsvorrichtung und einem fehlerbehafteten Übertragungskanal;

Figur 3 eine bildhafte Darstellung des Codierprinzips eines zweidimensionalen Reed-Solomon Codierverfahrens mit Quellensymbolen und horizontalen bzw. vertikalen Paritätssymbolen;

Figur 4a und 4b eine bildhafte Darstellung der empfangenen Codesymbole, wobei die empfangenen Codesymbole gemäß dem erfindungsgemäßen Verfahren ausgewertet werden;

Figur 5 Anwendung einer erfindungsgemäßen Vorrichtung in einem tragbaren Gerät.

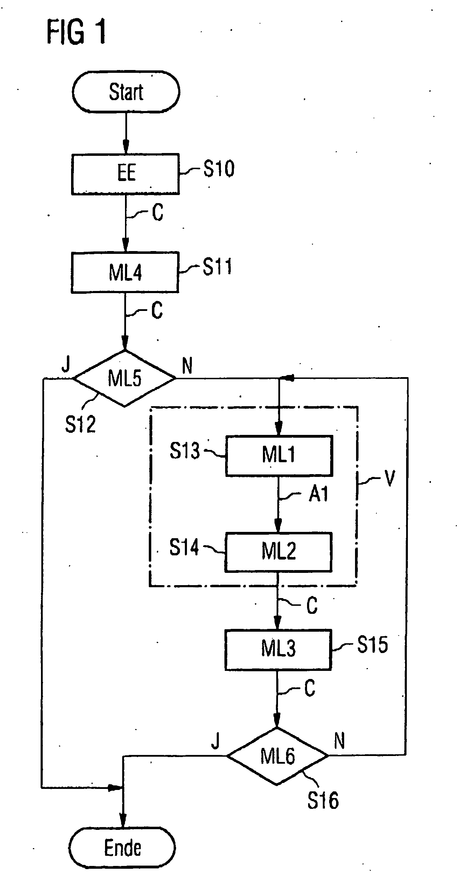

Elemente mit gleicher Funktion und Wirkungsweise sind in den Figuren 1 mit 5 mit denselben Bezugszeichen versehen.

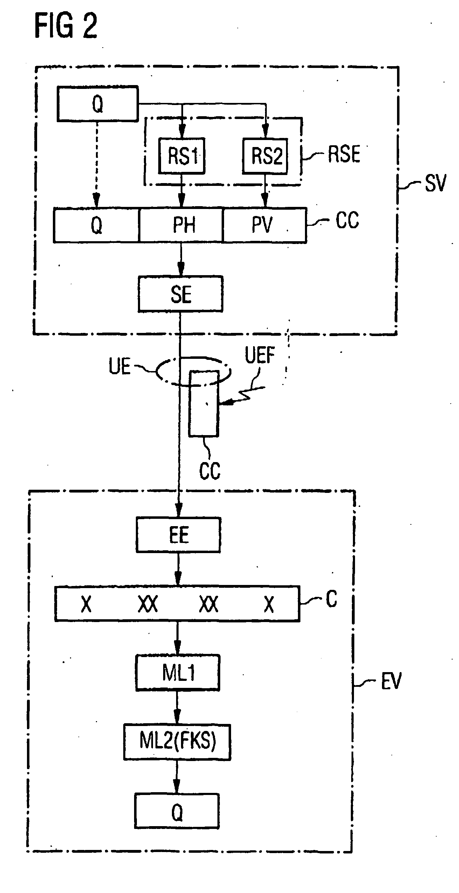

Mit Hilfe der Figuren 1 und 2 wird das erfindungsgemäße Verfahren näher erläutert. In Figur 2 ist eine Sendevorrichtung SV, bspw. eine MBMS-Sendevorrichtung (MBMS - Multimedia Broadcast/Multicast Service), zu sehen. Diese Sendevorrichtung SV codiert mit Hilfe eines zweidimensionalen Reed-Solomon-Codes RSE, wie z.B. mit einem zweidimensionalen Reed-Solomon-Encoder, Quellensymbole Q. Diese Quellensymbole Q repräsentieren bspw. eine komprimierte Sprach- oder Bilddatei. So sind die komprimierte Sprachdatei z.B. nach AMR-Standard (AMR - Adaptive Multirate) und die komprimierte Bilddatei nach JPEG-Standard (JPEG - Joint Picture Expert Group) codiert worden. Die Quellensymbole Q können im Allgemeinen beliebige Daten beschreiben, welche komprimiert oder nicht komprimiert sein können.

Für das folgende Ausführungsbeispiel werden die zweidimensional organisierten Quellensymbole Q in einer zweidimensionalen, rechteckigen Matrix dargestellt, wie bspw.

$$Q = \begin{bmatrix} q11 & \cdots & q1l \\ \vdots & \ddots & \vdots \\ qk1 & \cdots & qkl \end{bmatrix}, \qquad (1)$$

wobei diese Matrix eine Dimension kxl aufweist. Die Koeffizienten q11, ..., qkl repräsentieren die einzelnen Quellensymbole Q. Dabei ist k eine Zeilenanzahl und 1 eine Spaltenanzahl.

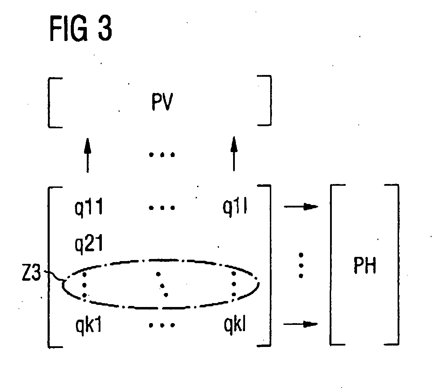

Der zweidimensionale Reed-Solomon-Encoder RSE umfasst einen ersten und zweiten Reed-Solomon Encoder PS1, RS2. Der erste Reed-Solomon Encoder RS1 erzeugt horizontale Paritätssymbole PH zeilenweise aus den jeweiligen Koeffizienten einer Zeile der zweidimensional organisierten Quellensymbole Q. Der zweite Reed-Solomon Encoder RS2 verwendet zur Codierung die jeweiligen Koeffizienten einer Spalte der zweidimensional organisierten Quellensymbole Q und generiert damit spaltenweise vertikale Paritätssymbole PV. Dieser Zusammenhang ist Figur 3 zu sehen.

Das zweidimensionale Reed-Solomon Fehlerschutzverfahren hat die Eigenschaft, dass so viele Quellensymbole und Paritätssymbole einer Zeile bzw. einer Spalte korrigiert werden können, wie Paritätssymbole in dieser Zeile bzw. Spalte vorhanden sind. In Figur 3 hat die dritte Zeile Z3 bspw. folgendes Aussehen:

$$Z3 = [q31, q32, q33, ph31, ph32] \qquad (2)$$

Dabei sind neben den Koeffizienten der Quellensymbolen Q mit einer Bezeichnung q31, q32, q33 zwei horizontale Paritätssymbole PH mit einer Bezeichnung ph31, ph32 vorhanden. Somit können in der dritten Zeile zwei beliebige Symbole, d.h. Quellensymbole Q und/oder horizontale Paritätssymbole PH, korrigiert werden. Diese Betrachtungsweise gilt analog für die Spalten.

Nach der Erstellung der horizontalen und vertikalen Paritätssymbole PH, PV werden codierte Codesymbole CC gebildet aus:

$$CC = [Q, PH, PV]. \qquad (3)$$

Bei der Übertragung der codierten Codesymbole CC von einer Sendeeinheit SE der Sendevorrichtung SV über einen Übertragungskanal UE zu einer Empfangseinheit EE einer Empfangsvorrichtung EV treten Übertragungsfehler UEF auf. Die Empfangsvorrichtung EV ist bspw. ein MBMS-Empfänger. Insbesondere bei der Übertragung über drahtlose Übertragungskanäle UE, z.B. über einen nach GSM-Standard (GSM - Global System for Mobile Communications) oder UMTS-Standard (UMTS - Universal Mobile Telecommunications System) arbeitenden Mobilfunkkanal, treten Übertragungsfehler UEF zu Tage. Ferner können auch drahtgebundene Übertragungskanäle, die z.B. mittels LAN-Standard und IP-Standard (LAN - Local Area Network, IP - Internet Protocol) betrieben werden, fehleranfällig sein. Dabei können codierte Codesymbole CC verfälscht empfangen werden, oder codierte Codesymbole CC werden bei der Übertragung ausgelöscht und erreichen die Empfangseinheit EE nicht. Die codierten Codesymbole CC erreichen die Empfangsvorrichtung EV als empfangene Codesymbole C. Dabei werden sowohl die ausgelöschten codierten Codesymbole CC als auch die verfälschten codierten Codesymbole CC als fehlerhaft empfangene Codesymbole C markiert, so dass eine Anzahl an codierten Codesymbolen CC gleich einer Anzahl an empfangenen Codesymbolen C ist. In Figur 2 sind fehlerhaft empfangene Codesymbole C, die z.B. aufgrund einer Verfälschung oder Auslöschung fehlerhaft sind, mit einem Bezugszeichen 'X' markiert. In Figur 1 erfolgt der Empfang der Codesymbole C im Schritt 10.

In einem nächsten Schritt S11 werden möglichst viele fehlerhaft empfangene Codesymbole C unter Verwendung eines zweidimensionalen Reed-Solomon Decodierverfahrens zu dekodiert bzw. rekonstruiert. Sind alle Quellensymbole Q aus den empfangenen Codesymbolen C fehlerfrei ermittelt worden, so wird im Schritt S12 ein Pfad mit einem Bezugszeichen J ausgewählt, der die Bearbeitung der empfangenen Codesymbole C beendet.

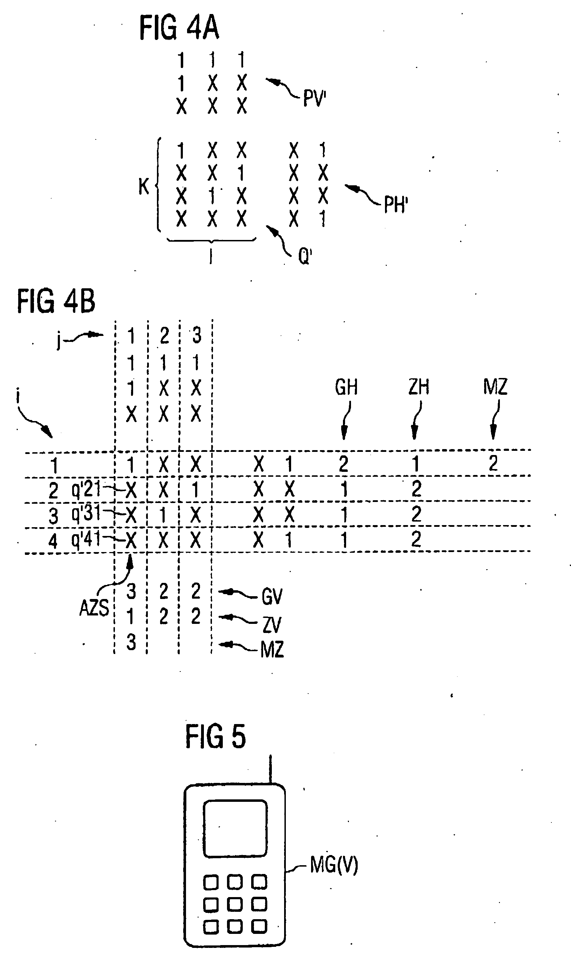

Konnten nicht alle Quellensymbole Q fehlerfrei rekonstruiert werden, so wird ein Pfad mit einem Bezugszeichen N durch Schritt S12 ausgewählt. Die empfangenen Codesymbole C werden in empfangene Quellensymbole Q' und empfangene horizontale und vertikale Paritätssymbole PH', PV' aufgeteilt. Eine derartige Aufteilung ist in Figur 4a dargestellt. Dabei zeigt ein Bezugszeichen 'X' an, dass das dazugehörige empfangene Codesymbole C fehlerhaft ist und ein Bezugszeichen '1', dass das zugehörige empfangene Codesymbol C fehlerfrei ist.

In einem weiteren Schritt S13 werden diejenigen Spalten aus den 1-Spalten und diejenigen zeile aus den k-Zeilen der zweidimensional organisierten, empfangenen Quellensymbole Q' selektiert, die eine minimale Anzahl an Fehlerkorrektursymbole FKS, d.h. zusätzliche codierte Codesymbole CC, benötigen, um alle Quellensymbole der entsprechenden Zeile bzw. Spalte fehlerfrei rekonstruieren zu können.

Dazu wird im Schritt S13 eine Anzahl an Fehlerkorrektursymbolen FKS für jede Zeile und jede Spalte der empfangenen Quellensymbole Q' ermittelt, die mindestens benötigt wird, um die empfangenen Quellensymbole Q' der jeweiligen Zeile bzw. Spalte vollständig rekonstruieren zu können. Diese Anzahl wird bei der zeilenweisen Betrachtung als erste Mindestanzahl ZH bei der spaltenweisen Betrachtung als zweite Mindestanzahl ZV bezeichnet. Die erste Mindestanzahl ZH ergibt sich aus:

$$ZH(i) = k - GH(i) \qquad (4)$$

wobei i die jeweils betrachtete Zeile spezifiziert und GH(i) eine Anzahl an fehlerfreien Quellensymbolen und fehlerfreien horizontalen Paritätssymbolen der Zeile i ist. In Figur 4b ergibt sich GH(i) aus der Summation der Bezugszeichen "1" über die empfangenen Quellensymbole Q' und empfangene horizontale Paritätssymbole PH' der Zeile i. So ist beispielsweise für die zweite Zeile i=2 die erste Mindestzahl ZH(i=2)=k-GH(i=2)=3-1=2. Die zweite Mindestanzahl ZV ergibt sich aus:

$$ZV(j) = l - GV(j) \qquad\qquad (5)$$

wobei j die jeweils betrachtete Spalte spezifiziert und GV(j) eine Anzahl an fehlerfreien Quellensymbolen und fehlerfreien vertikalen Paritätssymbolen der Spalte j ist. In Figur 4b ergibt sich GV(j) aus der Summation der Bezugszeichen "1" über die empfangenen Quellensymbole Q' und empfangene vertikalen Paritätssymbole PV' der Spalte j.

Im vorliegenden Beispiel gemäß Figur 4b benötigen die erste Zeile i=1 und die erste Spalte j=1 am wenigsten Fehlerkorrektursymbole FKS, da die erste Mindestanzahl ZH und die zweite Mindestanzahl ZV einen identischen Wert aufweisen ZH=ZV=1. Somit beträgt ein minimaler Wert MW=1. Das bedeutet, dass mit Hilfe einer Übertragung eines einzigen Fehlerkorrektursymbols FKS die fehlerhaft empfangenen Quellensymbole Q' der ersten Zeile bzw. der ersten Spalte der zweidimensional organisierten, empfangenen Quellensymbole Q' vollständig rekonstruiert werden können.

Somit umfasst eine Auswahlmenge A die erste Zeile und die erste Spalte, die bspw. mit folgender Markierung in die Auswahlmenge A eingefügt werden können:

$$A = \{i = 1, j = 1\} \qquad\qquad (6)$$

Die Auswahlmenge A wird in einem nachfolgenden Schritt S14 dahingehend analysiert, diejenige Spalte oder Zeile dieser Auswahlmenge A zu identifizieren, die eine maximale Anzahl von fehlerhaft empfangenen Quellensymbolen Q' in der identifizierten Spalte oder Zeile der zweidimensional organisierten, empfangenen Quellensymbole Q' korrigiert. Diese maximale Anzahl wird als maximale Korrekturanzahl MZ bezeichnet. Diese ergibt sich aus der Summation fehlerhaft empfangener Quellensymbole Q' pro Zeile bzw. pro Spalte der zweidimensional organisierten, empfangenen Quellensymbole Q'. So sind in der ersten Spalte j=1 des Beispiels gemäß Figur 4b drei empfangene Quellensymbole Q' fehlerhaft, und somit MZ=3. Nachdem jeweils für die Spalten bzw. zeilen der Auswahlmenge A die maximale Korrekturanzahl MZ ermittelt worden ist, wird diejenige Spalte bzw. Zeile ausgewählt, die die maximale Korrekturanzahl MZ aufweist. Im vorliegenden Beispiel ist dies die erste Spalte j=1 mit Mz=3, wobei diese Spalte mit einem Bezugszeichen AZS markiert ist. Im Vergleich dazu werden durch die erste Zeile i=1 lediglich zwei fehlerhaft empfangene Quellensymbole Q', d.h. MZ=2, korrigiert. Weisen mehrere Zeilen und/oder Spalten die identische maximale Korrekturanzahl MZ auf, so wird eine Zeile oder Spalte, insbesondere zufällig, ausgewählt.

Ferner wird eine Anzahl von Fehlerkorrektursymbolen FKS, wobei die Anzahl gleich dem minimalen Wert MW ist, selektiert. Dabei soll jedes selektierte Fehlerkorrektursymbol FKS eines der Quellensymbol (Q) umfassen, welches in der ausgewählten Zeile oder Spalte AZS als fehlerhaft empfangenes Quellenssymbol Q' markiert ist. Im Beispiel gemäß Figur 4b sind in der ausgewählten Zeile AZS die empfangenen Quellensymbole Q' (q'21, q'31, q'41) fehlerhaft, wobei das Bezugszeichen q' einzelne empfangene Quellensymbole Q' repräsentiert. Da der minimale Wert MW=1 ist, wird für eines dieser empfangenen Quellensymbole q'21, q'31, q'41 das dazugehörige fehlerfreie Quellensymbol in Form eines Fehlerkorrektursymbols FKS angefordert. So wird bspw. für das fehlerhaft empfangene Quellensymbol q'21 das dazugehörige Quellensymbol q21 in Form des Fehlerschutzsymbols FKS=q21 ausgewählt um angefordert zu werden.

In einem nachfolgenden Schritt S15 wird das Fehlerkorrektursymbol FKS durch die Empfangsvorrichtung EV von der Sendevorrichtung SV abgerufen. Nach Empfang des Fehlerkorrektursymbols FKS wird dieses an die Stelle des fehlerhaft empfangenen Quellensymbols Q', markiert mit dem Bezugszeichen q'21, kopiert. Danach werden die empfangenen Quellensymbole Q', die teilweise durch empfangene Fehlerkorrektursymbole FKS korrigiert worden sind, und die empfangenen horizontalen und vertikalen Paritätssymbole PH', PV' derart unter Verwendung des zweidimensionalen Reed-Solomon Decoders bearbeitet, dass eine maximale Anzahl von fehlerhaft empfangenen Quellensymbolen Q' rekonstruiert bzw. korrigiert wird. Sind alle empfangenen Quellensymbole Q' fehlerfrei rekonstruiert, so wählt der Schritt S16 den Pfad mit einer Markierung J, um das erfindungsgemäße Verfahren zu beenden. Ansonsten wird der Pfad mit dem Bezugszeichen N gewählt und die Schritte S13 bis S16 erneut durchlaufen. Die Verwendung eines zweidimensionalen Reed-Solomon Decoders ist einem Fachmann bekannt, so dass darauf nicht weiter eingegangen wird.

Das erfindungsgemäße Verfahren ist anhand von binären Symbolen beschrieben worden. Im Allgemeinen kann das erfindungsgemäße Verfahren mit binären Werten oder Werten eines Galois-Feldes GF, wie z.B. im Galois-Feld ($2^8$), benutzt werden.

Das erfindungsgemäße Verfahren ist mit einer Vorrichtung V durchführbar, wobei ein erstes Mittel ML1 den Schritt S13 und ein zweites Mittel ML2 den Schritt S14 implementiert und diese Mittel ML1, ML2 das erfindungsgemäße Verfahren ausführen. Ferner kann die Vorrichtung V derart ausgestaltet sein, dass mit einer Empfangseinheit EE der Schritt S10, einem vierten Mittel ML4 der Schritt S11, einem fünften Mittel ML5 der Schritt S12, einem dritten Mittel ML3 der Schritt S15 und einem sechsten Mittel ML6 der Schritt S16, ausgeführt werden kann.

Das erfindungsgemäße Verfahren wird in einem Endgerät EG mit Hilfe der Vorrichtung V durchgeführt. In Figur 5 ist ein derartiges Endgerät EG in Form eines tragbaren Geräts abgebildet. Dieses tragbare Gerät arbeitet bspw. nach einem Mobilfunkstandard, insbesondere nach GSM-Standard (GSM-Global System für Mobile Communications), UMTS-Standard (UMTS-Universal Mobile Telecommunications System), DAB-Standard (DAB-Digital Audio Broadcast) oder DVB-Standard (DVB-Digital Video Broadcast).

## Patentansprüche

1.  Verfahren zum Übertragen von Fehlerkorrektursymbolen (FKS), wobei für in einer zweidimensionalen Matrix organisierte Quellensymbole (Q) horizontale und vertikale Paritätssymbolen (PH, PV) unter Verwendung eines zweidimensionalen Reed-Solomon-Codes (RSE) generiert werden, die Quellensymbole (Q) und die horizontalen und vertikalen Paritätssymbole (PH, PV) von einer Sendevorrichtung (SV) zu einer Empfangsvorrichtung (EV) übertragen werden, wobei Übertragungsfehler in empfangenen Quellensymbolen (Q') und/oder in empfangenen horizontalen und/oder empfangenen vertikalen Paritätssymbolen (PH', PV') auftreten, **dadurch gekennzeichnet, dass** zu übertragende Fehlerkorrektursymbole (FKS) nach folgenden Schritten erzeugt werden:

    - eine erste Mindestanzahl (ZH) an Fehlerkorrektursymbolen (FKS) zur fehlerfreien Rekonstruktion fehlerhafter Quellensymbole (Q') einer Zeile der zweidimensional organisierten, empfangenen Quellensymbole (Q') wird, unter Berücksichtigung der zu dieser Zeile gehörenden, empfangenen horizontalen Paritätssymbole (PH'), zeilenweise ermittelt,
    - eine zweite Mindestanzahl (ZV) an Fehlerkorrektursymbolen (FKS) zur fehlerfreien Rekonstruktion fehlerhafter Quellensymbole (Q') einer Spalte der zweidimensional organisierten, empfangenen Quellensymbole (Q') wird, unter Berücksichtigung der zu dieser Spalte gehörenden, empfangenen vertikalen Paritätssymbole (PV'), spaltenweise ermittelt,
    - ein minimaler Wert (MW) wird aus der ersten und zweiten Mindestanzahl (ZH, ZV) bestimmt und eine jeweilige Markierung der zu diesem minimalen Wert (MW) jeweils gehörenden Zeile und/oder Spalte wird in eine Auswahlmenge (A) eingefügt,
    - aus der Auswahlmenge (A) wird diejenige Zeile oder Spalte (AZS) der zweidimensional organisierten, empfangenen Quellensymbole (Q') ausgewählt, die eine maximale Anzahl von fehlerhaft empfangenen Quellensymbole (Q') aufweist,
    - eine Anzahl an Fehlerkorrektursymbolen (FKS), wobei die Anzahl gleich dem minimalen Wert (MW) ist, wird durch die Empfangsvorrichtung (EV) angefordert und von der Sendevorrichtung (SV) übertragen, wobei jedes Fehlerkorrektursymbol (FKS) jeweils dasjenige Quellensymbol (Q) umfasst, welches in der ausgewählten Zeile oder Spalte (AZS) als fehlerhaft empfangenes Quellensymbol (Q') markiert ist.

2.  Verfahren nach Anspruch 1,
    **dadurch gekennzeichnet, dass**
    den Symbolen, insbesondere den Quellen-, horizontalen und vertikalen Paritätssymbolen (Q, PH, PV), binäre Werte oder Werte eines Galois-Feldes (GF) zugewiesen werden.

3.  Empfangsvorrichtung (EV) zum Durchführen eines Verfahrens zum Anfordern von Fehlerkorrektursymbolen (FKS), wobei für das Verfahren in einer Sendevorrichtung (SV) für in einer zweidimensionalen Matrix organisierte Quellensymbole (Q) horizontale und vertikale Paritätssymbole (PH, PV) unter Verwendung eines zweidimensionalen Reed-Solomon-Codes (RSE) generiert werden, die Quellensymbole (Q) und die horizontalen und vertikalen Paritätssymbolen (PH, PV) von der Sendevorrichtung (SV) zu der Empfangsvorrichtung (EV) übertragen werden, wobei Übertragungsfehler in empfangenen Quellensymbolen (Q') und/oder in empfangenen horizontalen und/oder empfangenen vertikalen Paritätssymbolen (PH', PV') auftreten,
    **gekennzeichnet durch**,
    ein erstes Mittel (ML1)

    - zum Ermitteln einer ersten Mindestanzahl (ZH) an Fehlerkorrektursymbolen (FKS) zur fehlerfreien Rekonstruktion fehlerhafter Quellensymbole (Q') einer Zeile der zweidimensional organisierten, empfangenen Quellensymbole (Q'), unter Berücksichtigung der zu dieser Zeile gehörenden, empfangenen horizontalen Paritätssymbole (PH'), pro Zeile,
    - zum Ermitteln einer zweiten Mindestanzahl (ZV) an Fehlerkorrektursymbolen (FKS) zur fehlerfreien Rekonstruktion fehlerhafter Quellensymbole (Q') einer Spalte der zweidimensional organisierten, empfangenen Quellensymbole (Q'), unter Berücksichtigung der zu dieser Spalte gehörenden, empfangenen vertikalen Paritätssymbole (PV'), pro Spalte,
- zum Bestimmen eines minimalen Werts (MW) aus der ersten und zweiten Mindestanzahl (ZH, ZV) und zum Einfügen einer jeweiligen Markierung der zu diesem minimalen Wert (MW) jeweils gehörenden Zeile und/oder Spalte in eine Auswahlmenge (A), ein zweites Mittel (ML2)
- zum Auswählen aus der Auswahlmenge (A) derjenigen Zeile oder Spalte (AZS) der zweidimensional organisierten, empfangenen Quellensymbole (Q'), die eine maximale Anzahl von fehlerhaft empfangenen Quellensymbole (Q') aufweist,
- zum Anfordern einer Anzahl an Fehlerkorrektursymbolen (FKS) von der Sendevorrichtung (SV), wobei die Anzahl gleich dem minimalen Wert (MW) ist, und wobei jedes Fehlerkorrektursymbol (FKS) jeweils dasjenige Quellensymbol (Q) umfasst, welches in der ausgewählten Zeile oder Spalte (AZS) als fehlerhaft empfangenes Quellensymbol (Q') markiert ist.

4. Endgerät (EG), insbesondere ein tragbares Gerät nach einem Mobilfunkstandard, insbesondere nach GSM-Standard, UMTS-Standard oder DVB-Standard, **dadurch gekennzeichnet, dass** eine Empfangs-Vorrichtung (EV) nach Anspruch 3 integriert ist.

**Claims**

1. A method for transmitting error correction symbols (FKS), wherein horizontal and vertical parity symbols (PH, PV) are generated using a two-dimensional Reed-Solomon code (RSE) for source symbols (Q) organized in a two-dimensional matrix, the source symbols (Q) and the horizontal and vertical parity symbols (PH, PV) are transmitted from a transmitting device (SV) to a receiving device (EV), transmission errors occur in received source symbols (Q') and/or in received horizontal and/or received vertical parity symbols (PH', PV'), **characterized in that** error correction symbols (FKS) to be transmitted are generated according to the following steps:

   - a first minimum number (ZH) of error correction symbols (FKS) are determined line by line for the error-free reconstruction of erroneous source symbols (Q') of a line of the two-dimensionally organized received source symbols (Q') in consideration of the received horizontal parity symbols (PH') pertaining to said line,
   - a second minimum number (ZV) of error correction symbols (FKS) are determined column by column for the error-free reconstruction of erroneous source symbols (Y') of a column of the two-dimensionally organized received source symbols (Q') in consideration of the received vertical parity symbols (PV') pertaining to said column,
   - a minimum value (MV) is determined from the first and second minimum number (ZV, ZV) and a corresponding marking of the line and/or column respectively pertaining to said minimum value (MW) is inserted into a selection set (A),
   - that line or column (AZS) of the two-dimensionally organized received source symbols (Q') is selected from the selection set (A) that has a maximum number of erroneously received source symbols (Q'),
   - a number of error correction symbols (FKS), the number being equal to the minimum value (MW), is requested by the receiving device (EV) and transmitted by the transmitting device (SV), each error correction symbol (FKS) comprising that source symbol (Q) that in the selected line or column (AZS) is marked as erroneously received source symbol (Q').

2. The method according to claim 1,
   **characterized in that**
   binary values or values of a Galois field (GF) are assigned to the symbols, particularly the source, horizontal and vertical parity symbols (Q, PH, PV).

3. A receiving device (EV) for carrying out a method for requesting error correction symbols (FKS), wherein horizontal and vertical parity symbols (PH, PV) are generated using a two-dimensional Reed-Solomon code (RSE) for the method in a transmitting device (SV) for source symbols (Q) organized in a two-dimensional matrix, the source symbols (Q) and the horizontal and vertical parity symbols (PH, PV) are transmitted from the transmitting device (SV) to the receiving device (EV), transmission errors occur in received source symbols (Q') and/or in received horizontal and/or received vertical parity symbols (PH', PV'),
   **characterized by**
   first means (ML1)

   - for determining a first minimum number (ZH) of error correction symbols (FKS) for the error-free reconstruction of erroneous source symbols (Q') of a line of the two-dimensionally organized received source symbols (Q') in consideration of the received horizontal parity symbols (PH') pertaining to said line, per line,
- for determining a second minimum number (ZV) of error correction symbols (FKS) for the error-free reconstruction of erroneous source symbols (Q') of a column of the two-dimensionally organized received source symbols (Q') in consideration of the received vertical parity symbols (PV') pertaining to said column, per column,
- for determining a minimum value (MW) from the first and second minimum number (ZH, ZV) and for inserting a respective marking of the line and/or column respectively pertaining to said minimum value (MW), in a selection set (A),

second means (ML2)

- for selecting in the selection set (A) that line or column (AZS) of the two-dimensionally organized received source symbols (Q') that has a maximum number of erroneously received source symbols (Q'),
- for requesting a number of error correction symbol (FKS) from the transmitting device (SV), wherein the number is equal to the minimum value (MV), and wherein each error correction symbol (FKS) comprises that source symbol (Q) that is marked in the selected line or column (AZS) as erroneously received source symbol (Q').

4. An end device (EG), particularly a portable device according to a mobile radio standard, particularly according to the GSM standard, UMTS standard or DVB standard, **characterized in that** a receiving device (EV) according to claim 3 is integrated.

**Revendications**

1. Procédé de transmission de symboles de correction d'erreurs (FKS), des symboles de parité horizontaux et verticaux (PH, PV) étant générés pour des symboles sources (Q) organisés dans une matrice bidimensionnelle à l'aide d'un code Reed-Solomon (RSE) bidimensionnel, les symboles sources (Q) et les symboles de parité horizontaux et verticaux (PH, PV) étant transmis d'un dispositif d'émission (SV) à un dispositif de réception (EV), étant précisé que des erreurs de transmission apparaissent dans des symboles sources reçus (Q') et/ou dans des symboles de parité horizontaux et/ou verticaux reçus (PH', PV'), **caractérisé en ce que** des symboles de correction d'erreurs (FKS) à transmettre sont générés selon les étapes suivantes :

- un premier nombre minimal (ZH) de symboles de correction d'erreurs (FKS) pour la reconstruction sans erreur des symboles sources erronés (Q') d'une ligne de symboles sources reçus (Q') organisés dans une matrice bidimensionnelle est déterminé ligne par ligne en prenant en compte les symboles de parité (PH') horizontaux reçus appartenant à cette ligne,
- un second nombre minimal (ZV) de symboles de correction d'erreurs (FKS) pour la reconstruction sans erreur des symboles sources erronés (Q') d'une colonne de symboles sources reçus (Q') organisés dans une matrice bidimensionnelle est déterminé colonne par colonne en prenant en compte les symboles de parité (PV') verticaux reçus appartenant à cette colonne,
- une valeur minimale (MW) à partir du premier et du second nombre minimal (ZH, ZV) est définie et une marque respective de la ligne et/ou colonne appartenant respectivement à cette valeur minimale (MW) est introduite dans un ensemble de sélection (A),
- à partir de l'ensemble de sélection (A), cette ligne ou colonne (AZS) de symboles sources reçus (Q') organisés dans une matrice bidimensionnelle est sélectionnée, laquelle comporte un nombre maximal de symboles sources reçus erronés (Q'),
- un nombre de symboles de correction d'erreurs (FKS), le nombre étant égal à la valeur minimale (MW), est demandé par le dispositif de réception (EV) et est transmis par le dispositif d'émission (SV), chaque symbole de correction d'erreurs (FKS) comprenant respectivement le symbole source (Q) qui est identifié dans la ligne ou colonne sélectionnée (AZS) comme symbole source reçu erroné (Q').

2. Procédé selon la revendication 1,
   **caractérisé en ce que**
   des valeurs binaires ou des valeurs d'un champ de Galois (GF) sont attribuées aux symboles, en particulier aux symboles sources, symboles de parité horizontaux et verticaux (Q, PH, PV).

3. Dispositif de réception (EV) pour la mise en oeuvre d'un procédé de demande de symboles de correction d'erreurs (FKS), dans lequel pour le procédé dans un dispositif d'émission (SV) pour des symboles sources (Q) organisés dans une matrice bidimensionnelle, des symboles de parité horizontaux et verticaux (PH, PV) sont générés à l'aide d'un code Reed-Solomon (RSE) bidimensionnel, les symboles source (Q) et les symboles de parité horizontaux et verticaux (PH, PV) étant transmis du dispositif d'émission (SV) au dispositif de réception (EV), étant précisé que des erreurs de transmission apparaissent dans les symboles sources reçus (Q') et/ou dans les symboles de parité horizontaux et/ou verticaux reçus (PH', PV'),
**caractérisé par**
un premier moyen (ML1)

- pour déterminer ligne par ligne un premier nombre minimal (ZH) de symboles de correction d'erreurs (FKS) pour la reconstruction sans erreur des symboles sources erronés (Q') d'une ligne de symboles sources reçus (Q') organisés dans une matrice bidimensionnelle, en prenant en compte les symboles de parité (PH') horizontaux reçus appartenant à cette ligne,
- pour déterminer colonne par colonne un second nombre minimal (ZV) de symboles de correction d'erreurs (FKS) pour la reconstruction sans erreur des symboles sources erronés (Q') d'une colonne de symboles sources reçus (Q') organisés dans une matrice bidimensionnelle, en prenant en compte les symboles de parité (PV') verticaux reçus appartenant à cette colonne,
- pour définir une valeur minimale (MW) à partir du premier et du second nombre minimal (ZH, ZV) et pour introduire une marque respective de la ligne et/ou colonne appartenant respectivement à cette valeur minimale (MW) dans un ensemble de sélection (A),

un second moyen (ML2)

- pour sélectionner à partir de l'ensemble de sélection (A) cette ligne ou colonne (AZS) des symboles sources reçus (Q') organisés dans une matrice bidimensionnelle, laquelle comporte un nombre maximal de symboles sources reçus erronés (Q'),
- pour demander un nombre de symboles de correction d'erreurs (FKS) par le dispositif d'émission (SV), le nombre étant égal à la valeur minimale (MW), et chaque symbole de correction d'erreurs (FKS) comprenant respectivement le symbole source (Q) qui est identifié dans la ligne ou colonne sélectionnée (AZS) comme symbole source reçu erroné (Q').

4. Appareil terminal (EG), en particulier un appareil portable conforme à une norme de téléphonie mobile, en particulier conforme à une norme GSM, UMTS ou DVB, **caractérisé en ce qu'**un dispositif de réception (EV) selon la revendication 3 est intégré.

## FIG 1

```
           ┌─────────┐
           │  Start  │
           └─────────┘
                │
                ▼
           ┌─────────┐
           │   EE    │──── S10
           └─────────┘
                │
                │─ C
                ▼
           ┌─────────┐
           │   ML4   │──── S11
           └─────────┘
                │
                │─ C
                ▼
    J        ╱◇╲        N
   ◄────────◇ ML5 ◇────────►
             ╲◇╱
            S12
                          ┌─────────┐
                    S13 ──│   ML1   │
                          └─────────┘      V
                               │
                               │─ A1
                               ▼
                          ┌─────────┐
                    S14 ──│   ML2   │
                          └─────────┘
                               │
                               │─ C
                               ▼
                          ┌─────────┐
                          │   ML3   │──── S15
                          └─────────┘
                               │
                               │─ C
                               ▼
              J            ╱◇╲            N
         ◄────────────────◇ ML6 ◇────────────────►
                           ╲◇╱
                          S16
                │
                ▼
           ┌─────────┐
           │  Ende   │
           └─────────┘
```

# FIG 2

# FIG 3

$$
\begin{bmatrix} & PV & \end{bmatrix}
$$

$$\uparrow \quad \cdots \quad \uparrow$$

Z3

$$
\begin{bmatrix}
q11 & \cdots & q1l \\
q21 & & \\
\vdots & \vdots & \vdots \\
qk1 & \cdots & qkl
\end{bmatrix}
\begin{array}{c} \rightarrow \\ \vdots \\ \rightarrow \end{array}
\begin{bmatrix} & PH & \end{bmatrix}
$$

## FIG 4A

```
1 1 1
1 X X      ← PV'
X X X
```

```
    1 X X   X 1
    X X 1   X X      ← PH'
K   X 1 X   X X
    X X X   X 1
         └─── Q'
    └──┬──┘
       i
```

## FIG 4B

|  | | 1 | 2 | 3 | | | GH | ZH | MZ |
|---|---|---|---|---|---|---|---|---|---|
| j → | | 1 | 1 | 1 | | | | | |
| | | 1 | 1 | 1 | | | | | |
| i | | 1 | X | X | | | | | |
| | | X | X | X | | | | | |
| 1 | | 1 | X | X | | X 1 | 2 | 1 | 2 |
| 2 q'21→ | | X | X | 1 | | X X | 1 | 2 | |
| 3 q'31→ | | X | 1 | X | | X X | 1 | 2 | |
| 4 q'41→ | | X | X | X | | X 1 | 1 | 2 | |

```
AZS   3   2   2   ← GV
      1   2   2   ← ZV
      3           ← MZ
```

## FIG 5

MG(V)

13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **WU et al.** Integrated Packet Loss And Error Control Schemes In Wireless Multimedia Data Links. *IEEE Global Telecommunications Conference,* 25. November 2001, 685-689

- **JENKAE et al.** Flexible Outer Reed-Solomon Coding on RLC Layer for MBMS over GERAN. *Vehicular Technology Conference,* 17. Mai 2004, 2777-2781
- Efficient FEC Code for Reliable MBMS User Services. *Technical Specification Group Services And System Aspects,* 14. Marz 2005, 1-12